(19) **Europäisches Patentamt**
**European Patent Office**
**Office européen des brevets**

(11) **EP 4 468 849 B1**

(12) **EUROPEAN PATENT SPECIFICATION**

(45) Date of publication and mention
of the grant of the patent:
**27.05.2026 Bulletin 2026/22**

(51) International Patent Classification (IPC):
*H10N 50/10* $^{(2023.01)}$     *G01R 33/09* $^{(2006.01)}$

(52) Cooperative Patent Classification (CPC):
**H10N 50/10; G01R 33/098**

(21) Application number: **23315217.2**

(22) Date of filing: **24.05.2023**

(54) **MAGNETORESISTIVE ELEMENT AND MAGNETIC SWITCH COMPRISING THE MAGNETORESISTIVE ELEMENT**

MAGNETORESISTIVES ELEMENT UND MAGNETSCHALTER MIT DEM MAGNETORESISTIVEN ELEMENT

ÉLÉMENT MAGNÉTORÉSISTIF ET COMMUTATEUR MAGNÉTIQUE COMPRENANT L'ÉLÉMENT MAGNÉTORÉSISTIF

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**27.11.2024 Bulletin 2024/48**

(73) Proprietor: **Allegro MicroSystems, LLC Manchester, NH 03103 (US)**

(72) Inventors:
• **SRELKOV, Nikita**
  **38240 Meylan (FR)**
• **TIMOPHEEV, Andrey**
  **38450 Vif (FR)**
• **DOUNIA, Salim**
  **38000 Grenoble (FR)**

(74) Representative: **South, Nicholas Geoffrey Venner Shipley LLP TIDE Bankside 8 Emerson Street London SE1 9DU (GB)**

(56) References cited:
EP-A1- 4 417 989       JP-A- 2005 223 158
US-A1- 2012 075 031   US-A1- 2012 106 240

• **STEINER MARCUS ET AL: "Control of magnetization states in microstructured permalloy rings", APPLIED PHYSICS LETTERS, AMERICAN INSTITUTE OF PHYSICS, 2 HUNTINGTON QUADRANGLE, MELVILLE, NY 11747, vol. 84, no. 6, 9 February 2004 (2004-02-09), pages 939 - 941, XP012062054, ISSN: 0003-6951, DOI: 10.1063/1.1646223**
• **KLAUI M ET AL: "Spin switching phase diagram of mesoscopic ring magnets", JOURNAL OF MAGNETISM AND MAGNETIC MATERIALS, ELSEVIER, AMSTERDAM, NL, vol. 290-291, 8 April 2005 (2005-04-08), pages 61 - 67, XP025364166, ISSN: 0304-8853, [retrieved on 20050401]**
• **NAKATANI R ET AL: "Magnetization reversal with in-plane magnetic field in asymmetric ring dots", JAPANESE JOURNAL OF APPLIED PHYSICS, JAPAN SOCIETY OF APPLIED PHYSICS, JP, vol. 42, no. 1, 1 January 2003 (2003-01-01), pages 100 - 101, XP002594642, ISSN: 0021-4922**
• **SUBRAMANI A ET AL: "Precise control of the vortex chirality in magnetic nano-rings with deliberately introduced asymmetry", PHYSICA C, NORTH-HOLLAND PUBLISHING, AMSTERDAM, NL, vol. 437-438, 15 May 2006 (2006-05-15), pages 293 - 298, XP027979607, ISSN: 0921-4534, [retrieved on 20060515]**

**EP 4 468 849 B1**

**(Cont. next page)**

- CHEN C C ET AL: "Controllable Remanent States on Microstructured Magnetic Tunnel Junction Rings", IEEE TRANSACTIONS ON MAGNETICS, IEEE, USA, vol. 43, no. 6, 21 May 2007 (2007-05-21), pages 2824 - 2826, XP011181557, ISSN: 0018-9464, DOI: 10.1109/ TMAG.2007.894206

## Description

## Technical domain

The present invention concerns a magnetoresistive element and a magnetic switch comprising the magnetoresistive element.

## Related art

A non-contact type magnetic switch using a tunnel magnetoresistive element are known. In this conventional non-contact type magnetic switch, a permanent magnet is disposed in the vicinity of a magnetoresistive element that exhibits the magnetoresistance effect, and a magnetic field of the permanent magnet acts on the magnetoresistive element. The magnetoresistive element has a lamination structure that is composed of a free layer (free magnetic layer), a non-magnetic layer, a fixed layer (pinned magnetic layer). The fixed layer is magnetized, and the magnetization direction is fixed to a particular direction. On the other hand, the magnetization direction of the free layer is varied by an external magnetic field.

A conventional magnetoresistive-based magnetic switch is usually configured to switch, i.e., to make or break contact, in the presence of an external magnetic field. When the strength of the external magnetic field acting on the magnetoresistive element is varied, the magnetization direction of the free layer is varied relative to the magnetization direction of the fixed layer and the magnitude of the resistance of the magnetoresistive element is thereby varied. The switch operation is performed based on an output signal that reflects a resistance variation of the magnetoresistive element. The switch operation can correspond to the switching between low resistance where the magnetization direction of the free layer is parallel to the magnetization direction of the fixed layer, and a high resistance where the magnetization direction of the free layer is antiparallel to the magnetization direction of the fixed layer. The switch between the low resistive states and high-resistive states occurs for a given magnitude of the external magnetic field (transition field).

Ideally, the low resistive and high-resistive states should be well separated. A conventional magnetoresistive-based magnetic switch is usually configured to switch in the presence of an external magnetic field moderate or weak magnetic field range, for example in the presence of an external magnetic field between 20 mT and 40 mT.

The transition field can be adjusted by modifying the arrangement and/or composition of the layers forming the magnetoresistive element. For example, the transition field can be adjusted by modifying the exchange bias of the sense layer. The transition field can further be modified by using a sense layer comprising a synthetic antiferromagnet with uniaxial magnetic anisotropy, or by using a hard biased sense layer.

However, modifying the arrangement and/or composition of the layers to adjust the transition field also involves separately controlling parameters of the magnetoresistive element, such as the tunnel magnetoresistance, magnetization, magnetic anisotropy, or coupling strength, over a wide range of temperatures. Each parameter that can have its own temperature dependance combines with the other parameters to determine the final properties of the magnetoresistive element. Moreover, the different parameters cannot be controlled independently. For example, the temperature dependence of magnetization, and magnetic anisotropy differs and cannot be controlled separately by modifying the arrangement and/or composition of the layers forming the magnetoresistive element.

JP 2005 223158 A discloses a tunnel junction which is formed by using a first magnetic layer provided with a hollow portion, a second magnetic layer having magnetic property different from the first magnetic layer, and a tunnel insulating layer interposed between the first and the second magnetic layers.

Kläui M et al: "Spin switching phase diagram of mesoscopic ring magnets", Journal of Magnetism and Magnetic Materials, vol. 290-291, 8 April 2005, discloses the switching phase diagram and the switching field trends of mesoscopic NiFe and Co ring magnets.

Nakatani R et al: "Magnetization reversal with in-plane magnetic field in asymmetric ring dots", Japanese Journal of Applied Physics, Japan Society of Applied Physics, vol. 42, no. 1, 1 January 2003, discloses asymmetric ring dots having partly planed outer sides, and their use in magnetic random access memory.

## Summary

The present invention provides a magnetoresistive element according to claim 1.

In another aspect, the present invention provides a magnetic switch according to claim 4.

The magnetoresistive element disclosed herein allows for obtaining a coreless vortex configuration of the sense magnetization and yields a resistance, or magnetization, hysteresis response that has no remanence at zero field. The resistance hysteresis response thus exhibits a well-defined rectangular-shaped loop that allows for obtaining two well distinguishable high-resistive and low resistive states in the positive magnetic field range. The magnetoresistive element is thus advantageous for a magnetic switch application.

## Short description of the drawings

Exemplary embodiments of the invention are disclosed in the description and illustrated by the drawings in which:

Fig. 1a illustrates a magnetoresistive element comprising a sense layer having a sense magnetization, the sense layer having a cross-sectional shape;

Fig. 1b is a top view of the magnetoresistive element of Fig. 1a showing the cross-sectional shape;

Fig. 2 reports the resistance of the magnetoresistive element experimentally measured as a function of the external magnetic field;

Fig. 3 shows simulations of the sense magnetization as a function of the external magnetic field;

Fig. 4 reports a resistance hysteresis response measured on the magnetoresistive element;

Fig. 5 shows the simulations of the magnetization hysteresis response for the magnetoresistive element of Fig. 4;

Figs. 6a to 6e are graphs showing the resistance hysteresis response measured for the magnetoresistive element having a sense layer with a thickness of 19 $\mu$m (Fig. 6a), 35 $\mu$m (Fig. 6b), 52 $\mu$m (Fig. 6c), 68 $\mu$m (Fig. 6d), and 85 $\mu$m (Fig. 6e);

Fig. 7 reports the expulsion field and nucleation field determined from resistance hysteresis responses measured on the magnetoresistive element;

Fig. 8 reports the simulated magnetization hysteresis response;

Fig. 9 reports the nucleation field determined from the simulated magnetization hysteresis response of Fig. 8;

Fig. 10 shows a square-shaped cross-sectional shape;

Fig. 11 shows a hexagonal-shaped cross-sectional shape shaped;

Fig. 12a shows the cross-sectional shape comprising two additional geometrical features;

Fig. 12b shows the magnetization hysteresis response for the cross-sectional shape of Fig. 12a;

Fig. 13a shows the cross-sectional shape comprising two additional geometrical features;

Fig. 13b shows the magnetization hysteresis response for the cross-sectional shape of Fig. 13a;

Fig. 14a shows the cross-sectional shape comprising two additional geometrical features;

Fig. 14b shows the magnetization hysteresis response for the cross-sectional shape of Fig. 14a;

Fig. 15a shows the cross-sectional shape comprising two additional geometrical features, according to an embodiment of the invention;

Fig. 15b shows the magnetization hysteresis response for the cross-sectional shape of Fig. 15a;

Fig. 16a shows the cross-sectional shape comprising two additional geometrical features, according to another embodiment of the invention; and

Fig. 16b shows the magnetization hysteresis response for the cross-sectional shape of Fig. 16a.

## Examples of embodiments

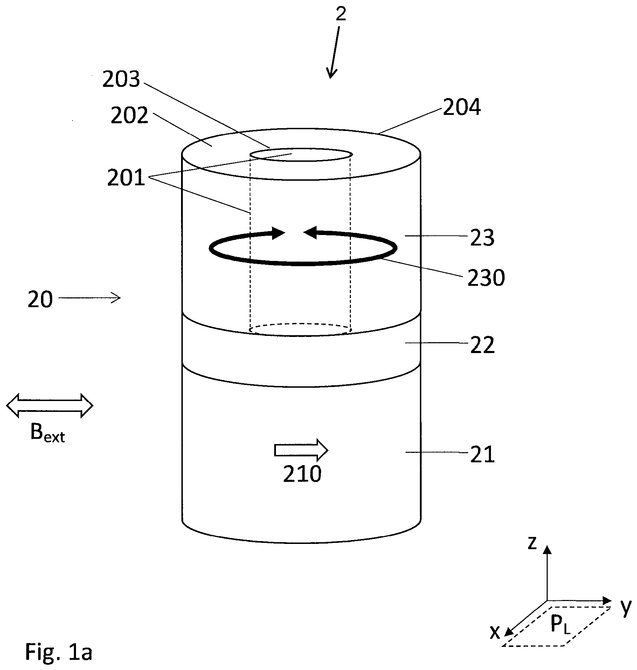

**Fig. 1a** illustrates a magnetoresistive element. The magnetoresistive element 2 is based on the tunnel magnetoresistance (TMR) effect and comprises a magnetic tunnel junction 20. In particular, the magnetoresistive element 2 comprises a tunnel barrier layer 22 sandwiched between a ferromagnetic reference layer 21 and a ferromagnetic sense layer 23. The reference layer 21 has a fixed reference magnetization 210. The sense layer 23 has a sense magnetization 230 that can be changed by an external magnetic field 60. The reference, tunnel barrier, and sense layers 21, 22, 23 extend in a layer plane $P_L$ and are stacked perpendicular to the layer plane $P_L$.

The reference and sense layers 21, 23 can comprise, or can be formed of, a ferromagnetic material such as a cobalt ("Co"), iron ("Fe") or nickel ("Ni") based alloy and preferentially a CoFe, NiFe or CoFeB based alloy. The reference layer 21 can have a thickness between 2 nm and 10 nm. The reference and sense layers 21, 23 can comprise a multilayer structure where each layer can include a ferromagnetic material such as a Co, Fe or Ni based alloy and preferentially a CoFe, NiFe or CoFeB based alloy, and non-magnetic layers such as Ta, Ti, W, Ru, Ir. The tunnel barrier layer 22 is a thin layer, typically in the nanometer range and can be formed, for example, from any suitable insulating material, such as alumina ($Al_2O_3$) or magnesium oxide (MgO).

In the reference: "M. Kläui, et al, "Vortex formation in narrow ferromagnetic rings", J. Phys. Cond. Matt. 15, R985 (2003)", the vortex formation in ring-shaped magnetoresistive elements is reported. The ring-shaped magnetoresistive elements can have bistable remanent state in the so-called "onion" magnetic state.

In the present disclosure, it is proposed to use a magnetoresistive element having a ring-shaped configuration and, more generally, a hollow cross-section configuration to obtain a coreless vortex state such that the magnetoresistive element can be switched between two resistive states.

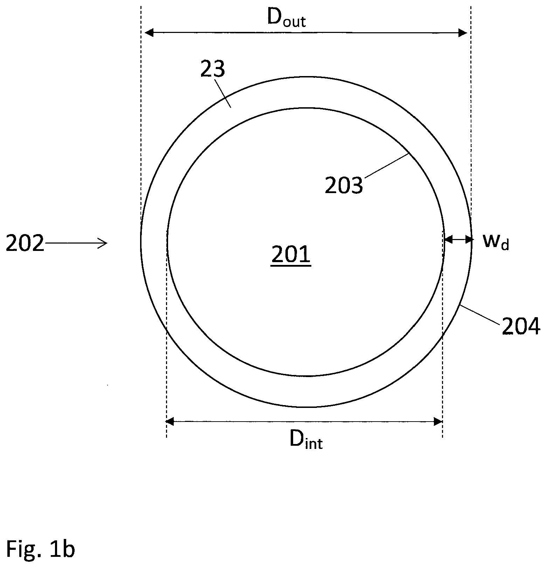

**Fig. 1b** is a top view of the magnetoresistive element 2 of Fig. 1a, showing the sense layer 23 in the layer plane $P_L$. In the layer plane $P_L$, at least a portion 20 of the magnetoresistive element 2 comprising the sense layer 23 has a hollow cross-sectional shape 202 in the layer plane $P_L$ having an inner lateral size $D_{int}$ and an exterior part having an outer side 204 with a lateral size $D_{out}$. The hollow cross-sectional shape comprises a hollow center 201. The width $w_d$ of the cross-sectional shape 202 corresponds to the difference between the outer lateral size $D_{out}$ and the inner lateral size $D_{int}$ divided by two (equation 1):

$$ w_d \ = \ (Dout - Dint)/2. \qquad\qquad \text{Eq. 1} $$

In the example of Figs. 1a and b, the cross-sectional shape 202 is ring-shaped and the inner lateral size $D_{int}$ and the outer lateral size $D_{out}$ are, respectively, the inner and outer diameter.

In possible embodiments, the portion 20 of the magnetoresistive element 2 can further comprise the sense layer 23 and the tunnel barrier layer 22. In another aspect, the portion 20 of the magnetoresistive element 2 can comprise the sense layer 23, the tunnel barrier layer 22 and the reference layer 21.

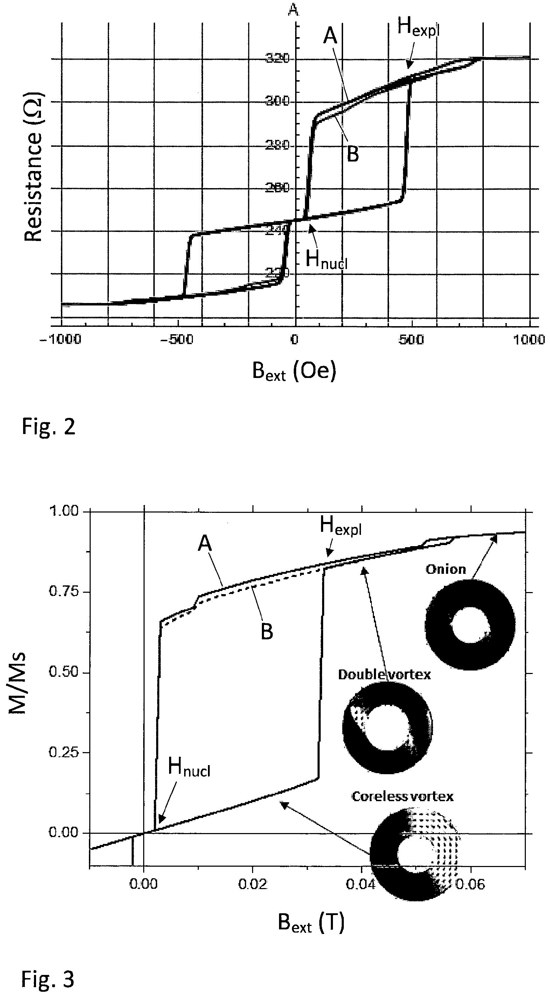

**Fig. 2** reports the resistance of the magnetoresistive element 2 experimentally measured as a function of the external magnetic field $B_{ext}$ (hereinafter resistance hysteresis response). The resistance hysteresis response corresponds to the change in resistance of the magnetoresistive element 2 due to the TMR effect. Here, the sense layer 23 is made of NiFe, 52 nm in thickness, and having a cross-sectional shape 202 with an inner diameter of 0.6 $\mu$m and an outer diameter of 1 $\mu$m (corresponding to a width $w_d$ of 0.2 $\mu$m). The inventors have found that the above dimensions of the ring-shaped sense layer 23 prevents the nucleation of a vortex core and results in a resistance hysteresis response having no remanence at zero field. The resistance hysteresis response exhibits two rectangular-shaped loops, one in the positive magnetic field range and another in the negative magnetic field range. The higher plateau of the resistance hysteresis response corresponds to the high-resistive state (onion magnetic state). The lower plateau of the resistance hysteresis response corresponds to the low-resistive state (coreless vortex configuration). The expulsion field $H_{expl}$ (here at about 450 Oe (= 35800 A/m)) corresponds to the transition from the high resistance state to the low resistance state (transition from the onion state to the coreless vortex configuration).

The magnetoresistive element 2 can thus be switched between two resistive states when the external magnetic field $B_{ext}$ is varied between a zero value and a positive value. Due to the well-defined rectangular shape of the loop in the positive magnetic field range, the magnetoresistive element 2 can be switched between two well distinguishable high-resistive and low resistive states (more than about 40 $\Omega$ in the example of Fig. 2) in the positive magnetic field range. Such behavior of the hysteresis response is useful for a magnetic switch application.

Since the sense magnetization 230 behaves in an isotropic manner, the magnetoresistive element 2 can be used as a magnetic switch to sense transitions at positive and negative the external magnetic field $B_{ext}$.

**Fig. 3** shows the simulations of the sense magnetization 230 as a function of the external magnetic field $B_{ext}$ (a magnetization hysteresis response). The simulations were performed for the magnetoresistive element 2 with the sense layer 23 made of NiFe, 52 nm in thickness, having a cross-sectional shape 202 with an inner diameter of 0.6 $\mu$m and an outer diameter of 1 $\mu$m. Below the nucleation field $H_{nucl}$, the sense magnetization 230 has a coreless vortex configuration. Above the expulsion field $H_{expl}$, the magnetization follows the circumference of the ring and forms the so-called 'onion' state, or onion configuration, so called as it resembles an onion sliced from top to bottom, which is characterized by two head-to-head domain walls. A transitional magnetic configuration, or "double vortex" configuration, can exist between the onion configuration and the coreless vortex configuration. The coreless vortex configuration is very stable.

In Figs 2 and 3, the respectively resistance hysteresis response and magnetization hysteresis response exhibit two well-defined rectangular-shaped loops when the external magnetic field $B_{ext}$ is varied and reaches saturation magnetization, i.e., above the expulsion field $H_{expl}$ (major loop) and when the external magnetic field $B_{ext}$ is varied without reaching saturation magnetization (minor loop).

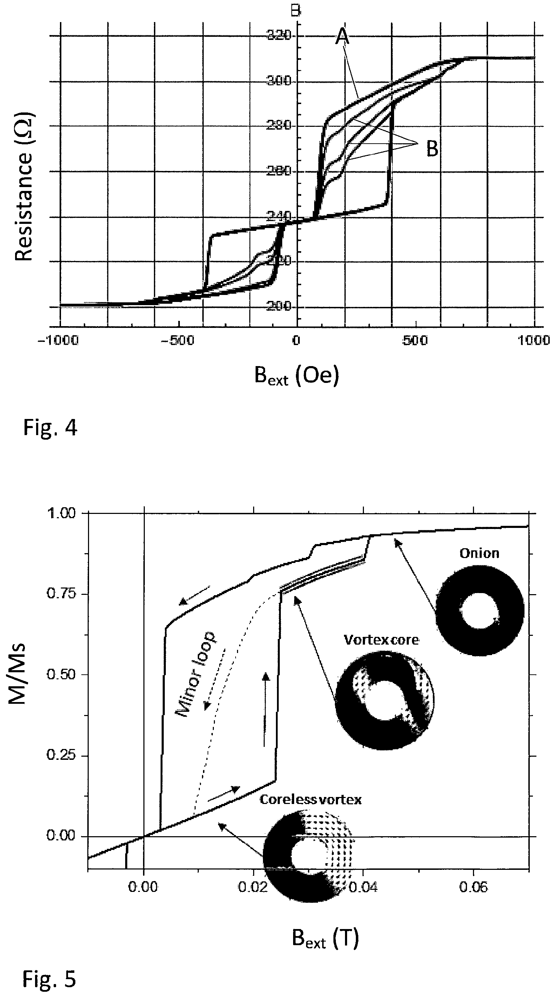

**Fig. 4** reports the resistance hysteresis response measured on the magnetoresistive element 2 with the sense layer 23 made of NiFe, 52 nm in thickness, having a cross-sectional shape 202 with an inner diameter of 0.5 $\mu$m and an outer diameter of 1 $\mu$m (corresponding to a width $w_d$ of 0.25 $\mu$m). **Fig. 5** shows the simulations of the magnetization hysteresis response for the magnetoresistive element 2 measured in Fig. 4. The magnitude of the sense magnetization 230 is substantially the same for the magnetoresistive elements 2 studied in Figs 2 to 5.

The resistance hysteresis response exhibits two well-defined rectangular-shaped loops when the external magnetic field $B_{ext}$ is varied such as to reach saturation magnetization (major loop). When the external magnetic field $B_{ext}$ is varied without reaching saturation magnetization (minor loop), the resistance hysteresis response does not exhibit a well-defined rectangular-shaped loop. Fig. 4 shows one major loop (loop A) and three minor loops (loops B). In the case of a minor loop, the sense magnetization 230 forms a vortex core, between magnetic "onion" and coreless vortex states. For the sense layer 23 having an inner diameter of 0.6 nm, i.e., a width $w_d$ of 0.2 $\mu$m (Figs. 2 and 3), the minor loops are superimposed and are almost identical to the major loop. The cross-sectional shape 202 of the sense layer 23, i.e., its outer and inner diameter, can thus be tailored to avoid the formation of a vortex core in the sense magnetization 230.

The configuration of the sense magnetization 230, and thus the shape of the resistance hysteresis response of the magnetoresistive element 2, is also influenced by other parameters than the outer $D_{out}$ and inner $D_{int}$ lateral size. For example, the shape of the resistance hysteresis response can be influenced by the thickness of the sense layer 23.

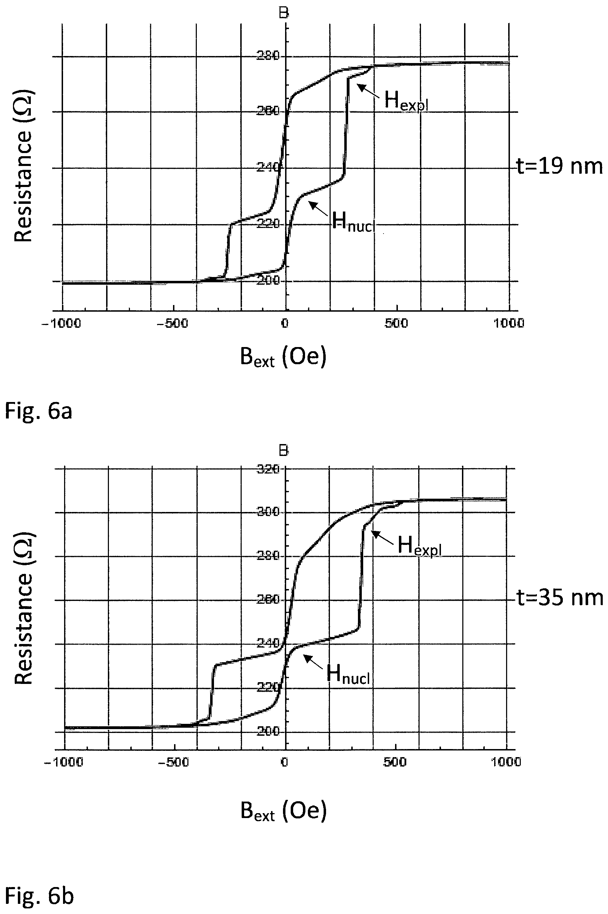

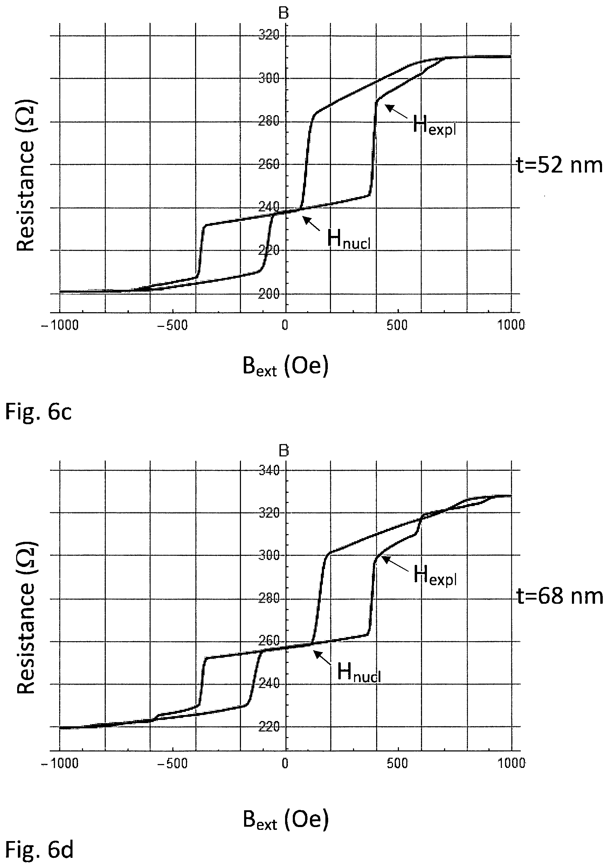

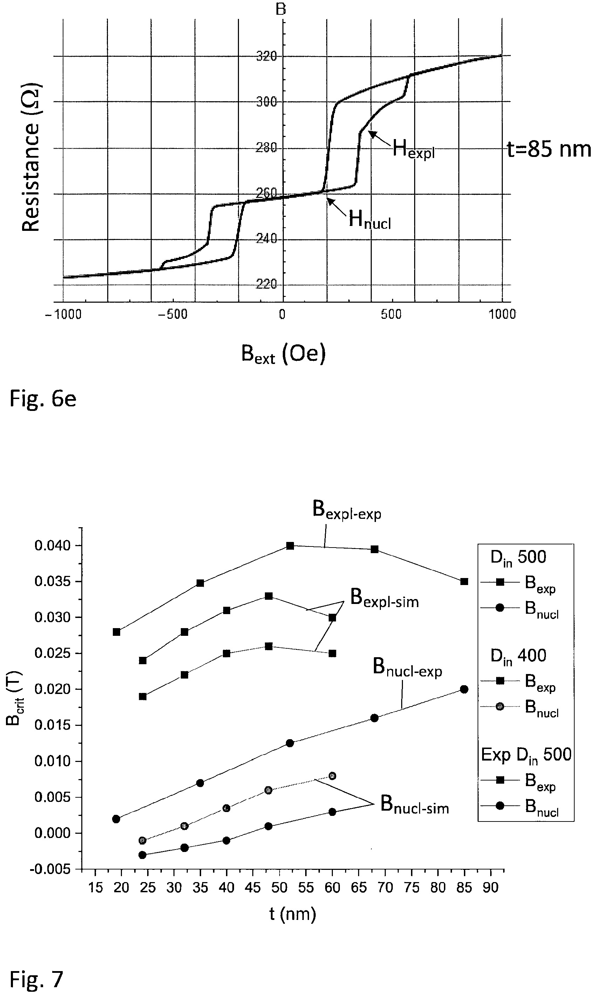

**Figs. 6a** to **6e** are graphs showing the resistance hysteresis response measured for the magnetoresistive element 2 having a sense layer 23 made of NiFe with a cross-sectional shape having an inner diameter $D_{int}$ of 1 $\mu$m and an inner diameter of 0.5 $\mu$m (width $w_d$ of 0.25 $\mu$m). More particularly, the resistance hysteresis response was measured for a thickness of the sense layer 23 of 19 $\mu$m (Fig. 6a), 35 $\mu$m (Fig. 6b), 52 $\mu$m (Fig. 6c), 68 $\mu$m (Fig. 6d), and 85 $\mu$m (Fig. 6e). From Figs 6a to 6e, the thicknesses of the sense layer 23 of 52 nm, 68 $\mu$m, and 85 $\mu$m yield the resistance hysteresis response having no remanence at zero field and exhibiting a rectangular-shaped loop, thus suitable for the magnetoresistive element 2 to be used as a magnetic switch.

**Fig. 7** reports the expulsion field $H_{expl-exp}$ and nucleation field $H_{nucl-exp}$ determined from resistance hysteresis responses measured on the magnetoresistive element 2 having a sense layer 23 made of NiFe with a cross-sectional shape 202 of 1 $\mu$m outer diameter $D_{out}$ and of 0.5 $\mu$m inner diameter (width $w_d$ of 0.25 $\mu$m), for different thickness t of the sense layer 23. Fig. 7 further reports the simulated expulsion field $H_{expl-sim}$ and nucleation field $H_{nucl-sim}$ for the sense layer 23 made of NiFe with a cross-sectional shape having an outer diameter $D_{out}$ of 1 $\mu$m and an inner diameter of 0.5 $\mu$m and 0.4 $\mu$m, as a function of the thickness t of the sense layer 23. In Fig. 7, "$B_{crit}$" is a critical field that can be either the expulsion field or the nucleation field.

Fig. 7 shows that the measured and simulated nucleation fields $H_{nucl-exp}$, $H_{nucl-sim}$ increase gradually with the thickness t of the sense layer 23. The measured and simulated expulsion fields $H_{expl-exp}$, $H_{expl-sim}$ pass through a maximum for a thickness t of the sense layer 23 that is about 50 nm. These results suggest that the thickness t of the sense layer 23 can be adjusted to maximize the gap between the expulsion field $H_{expl}$ and the nucleation field $H_{nucl}$, such as to obtain well distinguishable high-resistive and low resistive states optimal for magnetic switch applications. The thickness of the sense layer 23 can be further adjusted such that the resistance hysteresis response has no remanence at zero field and the nucleation field $H_{nucl}$ is above zero.

The inventors also found that the shape of the resistance hysteresis response can be influenced by the magnitude of the sense magnetization 230. More particularly, the expulsion field $H_{expl}$ can be modified by varying the sense magnetization 230, for example by diluting the sense magnetization 230. Since the exchange stiffness decreases with the magnetization, the nucleation field $H_{nucl}$ does not significantly vary with varying the sense magnetization 230.

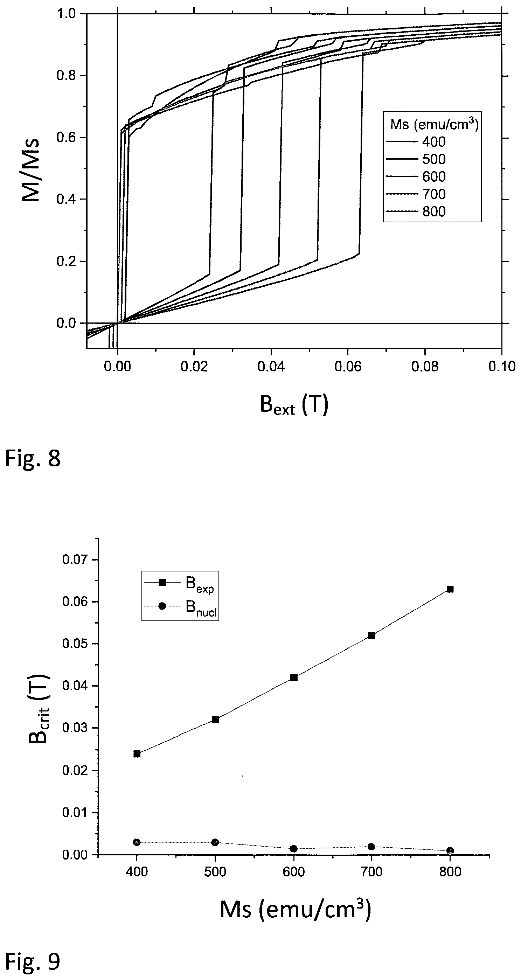

**Fig. 8** reports the simulated magnetization hysteresis response, i.e., the magnitude $M_s$ of the sense magnetization 230 as a function of the external magnetic field $B_{ext}$. The simulations were performed for the magnetoresistive element 2 with a NiFe sense layer 23 having an inner diameter of 0.5 $\mu$m and outer diameter of 1 $\mu$m (width of 0.25 $\mu$m). The sense magnetization 230 is varied between 400 and 800 emu/cm$^3$ ($4 \times 10^5$ and $8 \times 10^5$ A/m). The dependence of exchange stiffness $A_{ex}$ on the magnetization of NiFe sense layer 23 is considered in the simulations. As shown in **Fig. 9,** the nucleation field $H_{nucl}$, determined from the simulated magnetization hysteresis response, is almost constant within the magnetization range 400 and 800 emu/cm$^3$ ($4 \times 10^5$ and $8 \times 10^5$ A/m). The expulsion field $H_{expl}$ increases monotonically with the magnetization Ms. Figs 8 and 9 show that adjusting the sense magnetization 230 allows for increasing the expulsion field $H_{expl}$ and thus increasing the difference between the high-resistive and low resistive states.

Dimensions

The present inventors have shown that with the sense layer 23 having a hollow cross-sectional shape 202 with the outer side 204 having a lateral size $D_{out}$ between 1 $\mu$m and 5 $\mu$m and the width $w_d$ of the cross-sectional shape 202 between 0.2 $\mu$m and 0.3 $\mu$m, the sense magnetization 230 can have a closed flux path configuration without vortex core ("coreless vortex" configuration). The coreless vortex configuration is orientable either in the clockwise or counterclockwise direction. The coreless vortex configuration can further be stabilized at zero field, i.e., have zero remanence at zero external magnetic field.

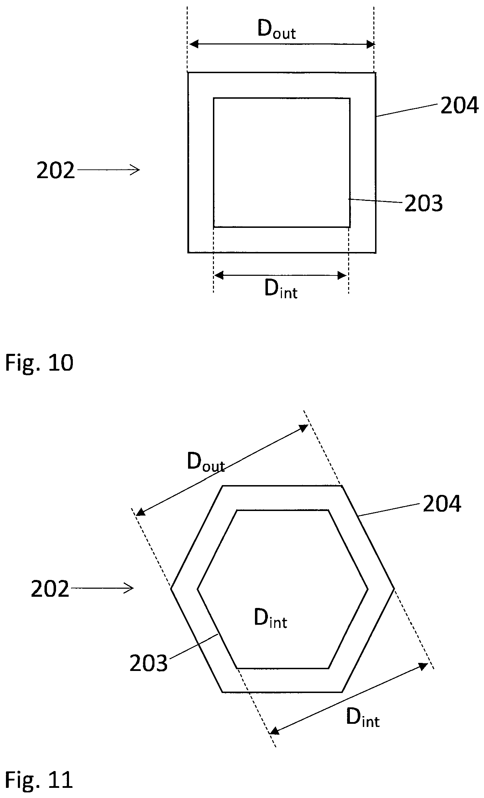

The cross-sectional shape 202 is not limited to a ring shape as exemplified in Figs. 1a and b. In some examples, the inner side 203 and outer side 204 of the cross-sectional shape 202 is square shaped (see **Fig. 10)** or hexagonal shaped (see **Fig. 11**). Other geometries of the cross-sectional shape 202 are possible (circular, elliptical, rectangular or other polygonal shape, etc.). The inner and outer sides 203, 204 can further have different combinations of geometries. For example, the inner side 203 can be circular and the outer side 204 can be hexagonal.

The transition field for high-resistive and low resistive states can be in part adjusted by modifying the arrangement and/or composition of the layers forming the magnetoresistive element and in part by modifying the lateral dimensions of the cross-sectional shape 202. For example, a lithographic mask can be provided with selected lateral dimensions of the cross-sectional shape 202 and the thickness of the sense layer 23, or the magnitude of the sense magnetization 230, can then be adjusted to tune the transition field. This approach facilitates the design and can lower the manufacturing costs of the magnetoresistive element 2. The magnetoresistive element 2 has low sensitivity to a magnetic field that is below the transition field. The magnetoresistive element 2 can further achieve a reproducible magnetization hysteresis response for a wide range of temperatures and magnetic fields.

Additional geometrical feature

In embodiments, the cross-sectional shape 202 of the magnetoresistive element 2 comprises an additional geometrical feature configured to improve the resistance hysteretic response. For example, the additional geometrical feature can be configured to impede the formation of a vortex core in the sense magnetization 230.

In examples, the additional geometrical feature comprises cuts, cut-outs or notches provided at symmetrical positions on the inner or outer diameter $D_{int}$, $D_{out}$ of the cross-sectional shape 202 of the magnetoresistive element 2. For instance, the cuts, cut-outs or notches can be provided on the cross-sectional shape 202 at locations where a vortex core is likely to appear.

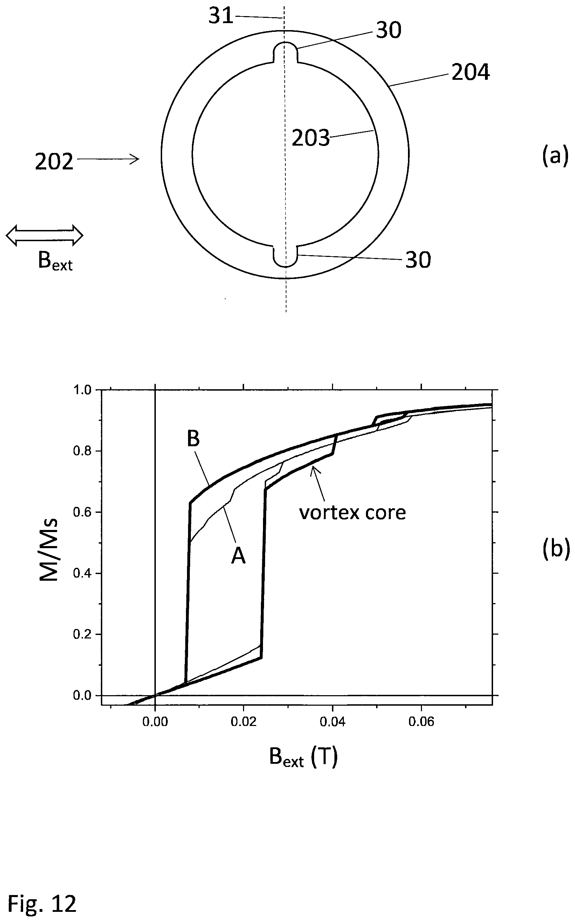

**Figs. 12** to **16** show the simulated magnetization hysteresis response of the magnetoresistive element 2 with the sense layer 23 is made of NiFe, and has a thickness of 60 nm and a magnitude of the sense magnetization 230 of $5 \times 10^5$ A/m. The cross-sectional shape 202 is annular and has an outer diameter of 1 $\mu$m and an inner diameter of 0.4 $\mu$m (width of 0.2 $\mu$m).

More particularly, **Fig. 12a** shows the cross-sectional shape 202 comprising two additional geometrical features 30, each comprising a notch arranged diametrically opposed on the inner side 203. The corresponding magnetization hysteresis response for the cross-sectional shape 202 of Fig. 12a (curve A) is shown in **Fig. 12b.** Also shown in Fig. 12b is the magnetization hysteresis response corresponding to the cross-sectional shape 202 in the absence of the two additional geometrical features 30 (curve B).

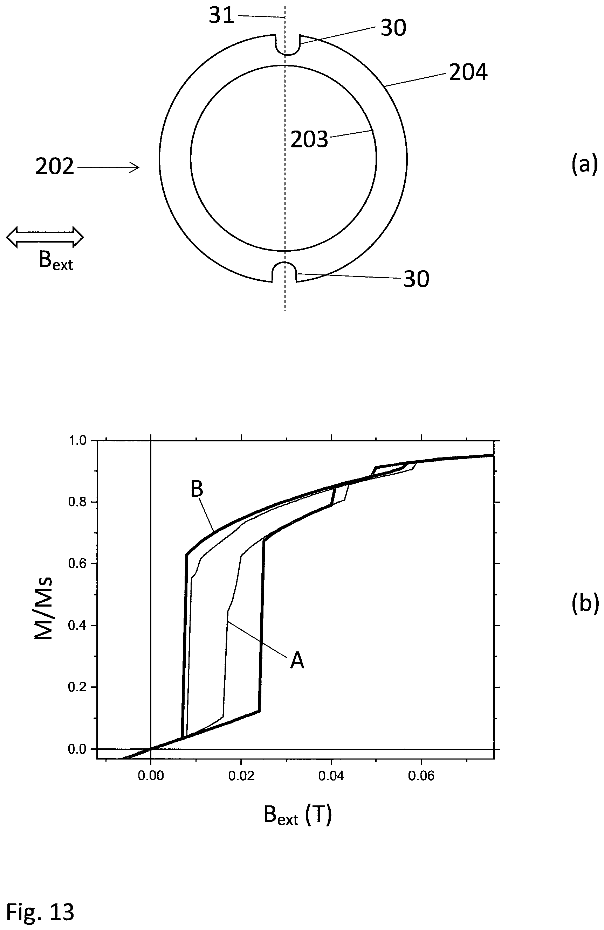

According to a variant, **Fig. 13a** shows the cross-sectional shape 202 comprising two additional geometrical features 30, each comprising a notch arranged diametrically opposed on the outer side 204. The corresponding magnetization hysteresis response for the cross-sectional shape 202 of Fig. 13a (curve A) is shown in **Fig. 13b.** Also shown in Fig. 13b is the magnetization hysteresis response corresponding to the cross-sectional shape 202 in the absence of the two additional geometrical features 30 (curve B).

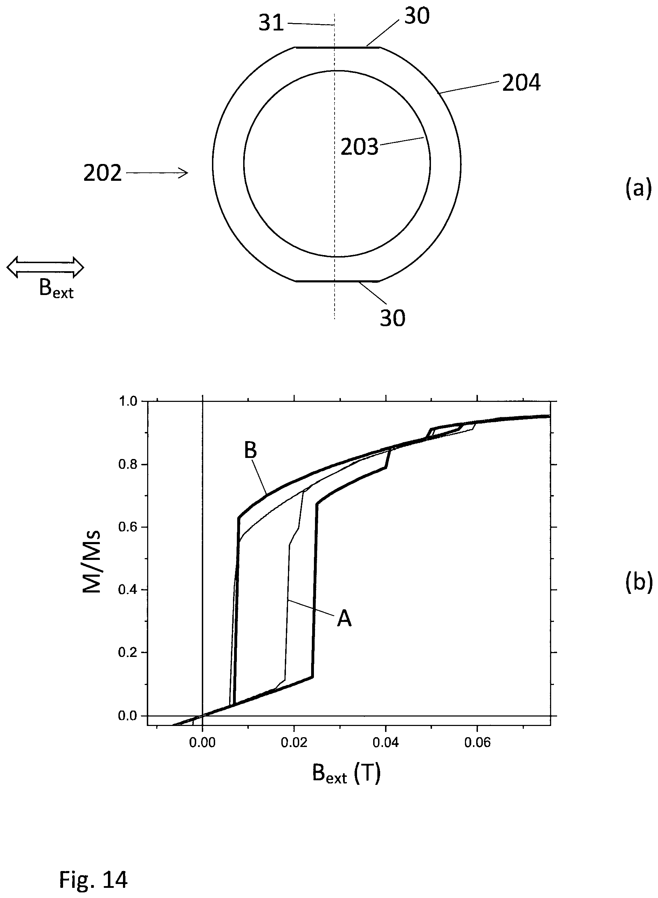

According to another variant, **Fig. 14a** shows the cross-sectional shape 202 comprising two additional geometrical features 30, each comprising a cut, of flat portion, arranged diametrically opposed on the outer side 204. The corresponding magnetization hysteresis response for the cross-sectional shape 202 of Fig. 14a (curve A) is shown in **Fig. 14b.** Also shown in Fig. 14b is the magnetization hysteresis response corresponding to the cross-sectional shape 202 in the absence of the two additional geometrical features 30 (curve B).

In the variants of Figs. 12 to 14, the two additional geometrical features 30 are preferably arranged substantially on the cross-sectional shape 202 along an axis 31 that is substantially perpendicular to the direction of the external magnetic field $B_{ext}$.

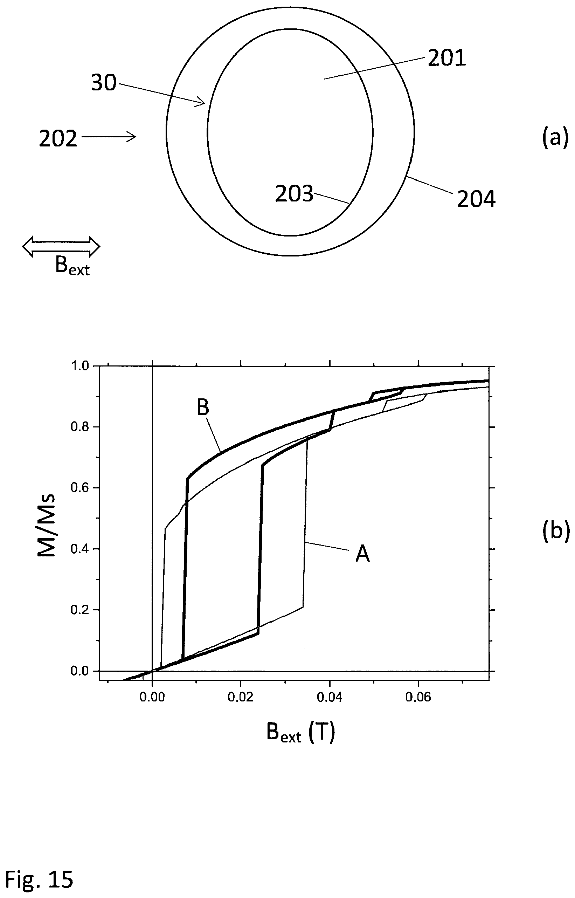

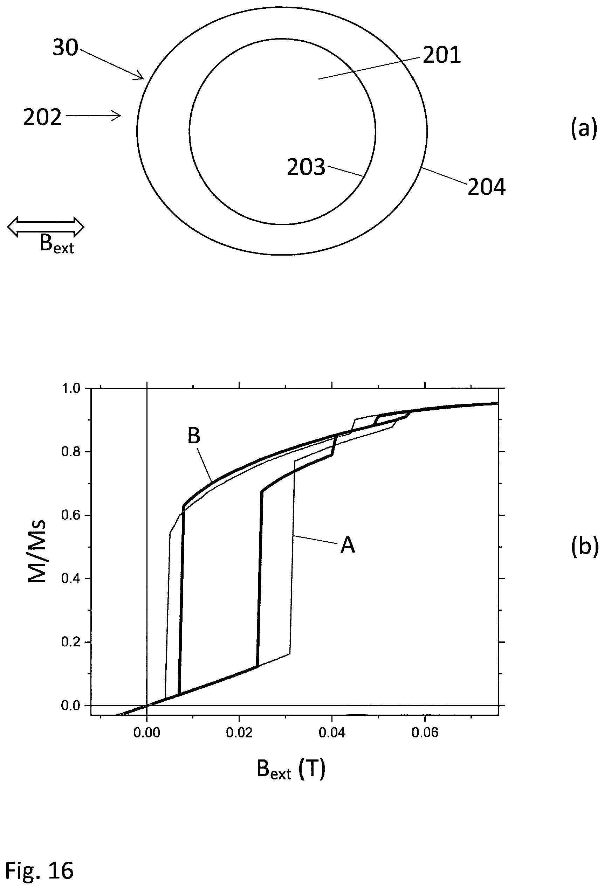

**Figs. 15** and **16** show the simulated magnetization hysteresis response of the magnetoresistive element 2 when the sense layer 23 is made of NiFe, and has a thickness of 60 nm and a magnitude of the sense magnetization 230 of $5 \times 10^5$ A/m. In the particular example of **Fig. 15a,** in accordance with the invention, the cross-sectional shape 202 has a circular-shaped outer side 204 having an outer diameter of 1 $\mu$m. The additional geometrical feature 30 comprises the inner side 203 having an ellipsoid shape. The corresponding magnetization hysteresis response for the cross-sectional shape 202 of Fig. 15a (curve A) is shown in **Fig. 15b.** Also shown in Fig. 15b is the magnetization hysteresis response corresponding to the cross-sectional shape 202 in the absence of the two additional geometrical features 30 (curve B).

In another particular example of **Fig. 16a,** in accordance with the invention, the cross-sectional shape 202 has a circular-shaped inner side 203 having an outer diameter of 0.4 μm. The additional geometrical feature 30 comprises the outer side 204 having an ellipsoid shape. The corresponding magnetization hysteresis response for the cross-sectional shape 202 of Fig. 16a (curve A) is shown in **Fig. 16b.** Also shown in Fig. 16b is the magnetization hysteresis response corresponding to the cross-sectional shape 202 in the absence of the two additional geometrical features 30 (curve B).

Figs. 15b and 16b show that in the case of the magnetoresistive element where the additional geometrical feature 30 comprises the ellipsoidal outer side 204 or ellipsoidal inner side 203 yields a magnetization hysteresis response with larger area than the magnetization hysteresis response without the additional geometrical feature 30.

The cross-sectional shape 202 of the magnetoresistive element 2 that comprises the additional geometrical feature allows for reducing the vortex core region (indicated in Fig. 12b) generating the undesired minor loop.

The additional geometrical feature 30 can have different geometrical shapes including circular, ellipsoidal, or polygonal cut-outs. The additional geometrical feature 30 should be configured to locally reduce the width $w_d$ of the of the cross-sectional shape 202 (without additional geometrical feature 30) by a factor that can be between 20% and 70% or less than 50%. The local reduction of the width $w_d$ of the of the cross-sectional shape 202 allows for avoiding the formation of a vortex core and thus, obtaining a well-defined rectangular shape of the magnetization hysteresis response. The additional geometrical feature 30 allows for varying the nucleation and expulsion fields $H_{nucl}$, $H_{expl}$ with zero remanence at zero field.

Preferably, the additional geometrical feature 30 is arranged symmetrically with respect to the center of the cross-sectional shape 202. Preferably, the additional geometrical feature 30 is also arranged substantially perpendicular to the direction of the external magnetic field $B_{ext}$.

By adapting the geometry of a ring-shaped magnetic magnetoresistive element, nucleation/expulsion transition fields can occur at desired fields with zero remanence at zero field.

Reference numbers and symbols

| | |
|---|---|
| 10 | magnetoresistive sensor device |
| 11 | first electrical connector |
| 12 | second electrical connector |
| 13 | via |
| 2 | magnetoresistive element |
| 20 | magnetic tunnel junction |
| 201 | interior center |
| 202 | cross-sectional shape |
| 203 | inner side |
| 204 | outer side |
| 21 | reference layer |
| 210 | reference magnetization |
| 211 | first reference sublayer |
| 212 | second reference sublayer |
| 213 | coupling layer |
| 22 | tunnel barrier layer |
| 23 | sense layer |
| 230 | sense magnetization |
| 30 | additional geometrical feature |
| 31 | axis |
| $B_{ext}$ | external magnetic field |
| $D_{int}$ | inner lateral size, inner diameter |
| $D_{out}$ | outer lateral size, outer diameter |
| $P_L$ | layer plane |
| $w_d$ | width |

**Claims**

**1.** Magnetoresistive element (2) comprising:

a tunnel barrier layer (22) sandwiched between a ferromagnetic reference layer (21) having a fixed reference magnetization (210), and a ferromagnetic sense layer (23) having a sense magnetization (230) that can be changed by an external magnetic field ($B_{ext}$);

wherein the ferromagnetic reference, tunnel barrier, and ferromagnetic sense layers (21, 22, 23) are stacked perpendicular to a layer plane ($P_L$) thereof;

wherein at least a portion (20) of the magnetoresistive element (2) comprising the ferromagnetic sense layer (23) has a hollow cross-sectional shape (202) in the layer plane ($P_L$), the hollow cross-sectional shape (202) having an outer side (204) with an outer lateral size ($D_{out}$) and an inner side (203) defining a width ($w_d$) of the hollow cross-sectional shape (202);

wherein the outer lateral size ($D_{out}$) is between 1 $\mu$m and 5 $\mu$m and the width ($w_d$) is between 0.2 $\mu$m and 0.3 $\mu$m; such that the sense magnetization (230) has a coreless vortex configuration and such that the magnetoresistive element (2) has zero remanence at zero external magnetic field ($B_{ext}$);

wherein the hollow cross-sectional shape (202) comprises an additional geometrical feature (30) configured to locally reduce the width ($w_d$) of the hollow cross-sectional shape (202) by less than 50%, such as to avoid the formation of a vortex core in the sense magnetization (230); and

wherein the additional geometrical feature (30) comprises: the inner side (203) having an ellipsoid shape and the outer side (204) having a circular shape; or the outer side (204) having an ellipsoid shape and the inner side (203) having a circular shape.

2. The magnetoresistive element according to claim 1,
   wherein the additional geometrical feature (30) is arranged symmetrically with respect to the center of the hollow cross-sectional shape (202).

3. The magnetoresistive element according to claim 1 or 2,
   wherein the additional geometrical feature (30) is arranged substantially perpendicular to the direction of the external magnetic field ($B_{ext}$).

4. A magnetic switch comprising the magnetoresistive element according to any one of claims 1 to 3.

**Patentansprüche**

1. Magnetoresistives Element (2), umfassend:

   eine Tunnelbarriereschicht (22), die zwischen einer ferromagnetischen Referenzschicht (21) mit einer festen Referenzmagnetisierung (210) und einer ferromagnetischen Erfassungsschicht (23) mit einer Erfassungsmagnetisierung (230), die durch ein externes Magnetfeld ($B_{ext}$) geändert werden kann, eingelegt ist;

   wobei die ferromagnetische Referenz-, Tunnelbarriere- und ferromagnetische Erfassungsschicht (21, 22, 23) senkrecht zu einer Schichtebene ($P_L$) davon gestapelt sind;

   wobei mindestens ein Abschnitt (20) des magnetoresistiven Elements (2), das die ferromagnetische Erfassungsschicht (23) umfasst, eine hohle Querschnittsform (202) in der Schichtebene ($P_L$) aufweist, wobei die hohle Querschnittsform (202) eine Außenseite (204) mit einer äußeren lateralen Größe ($D_{out}$) und eine Innenseite (203), die eine Breite ($w_d$) der hohlen Querschnittsform (202) definiert, aufweist;

   wobei die äußere laterale Größe ($D_{out}$) zwischen 1 $\mu$m und 5 $\mu$m liegt und die Breite ($w_d$) zwischen 0,2 $\mu$m und 0,3 $\mu$m liegt; sodass die Erfassungsmagnetisierung (230) eine kernlose Wirbelkonfiguration aufweist und sodass das magnetoresistive Element (2) bei null externem Magnetfeld ($B_{ext}$) null Remanenz aufweist;

   wobei die hohle Querschnittsform (202) ein zusätzliches geometrisches Merkmal (30) umfasst, das dazu konfiguriert ist, die Breite ($w_d$) der hohlen Querschnittsform (202) lokal um weniger als 50 % zu reduzieren, um so die Bildung eines Wirbelkerns in der Erfassungsmagnetisierung (230) zu vermeiden; und

   wobei das zusätzliche geometrische Merkmal (30) Folgendes umfasst: dass die Innenseite (203) eine ellipsoide Form aufweist und die Außenseite (204) eine kreisrunde Form aufweist; oder dass die Außenseite (204) eine ellipsoide Form aufweist und die Innenseite (203) eine kreisrunde Form aufweist.

2. Magnetoresistives Element nach Anspruch 1,
   wobei das zusätzliche geometrische Merkmal (30) symmetrisch in Bezug auf die Mitte der hohlen Querschnittsform (202) angeordnet ist.

3. Magnetoresistives Element nach Anspruch 1 oder 2,

wobei das zusätzliche geometrische Merkmal (30) im Wesentlichen senkrecht zu der Richtung des externen Magnetfelds ($B_{ext}$) angeordnet ist.

4. Magnetschalter, umfassend das magnetoresistive Element nach einem der Ansprüche 1 bis 3.

**Revendications**

1. Élément magnétorésistif (2) comprenant :

   une couche de barrière tunnel (22) prise en sandwich entre une couche de référence ferromagnétique (21) ayant une aimantation de référence fixe (210) et une couche de détection ferromagnétique (23) ayant une aimantation de détection (230) pouvant être modifiée par un champ magnétique externe ($B_{ext}$) ;
   dans lequel les couches de référence ferromagnétique, de barrière tunnel et de détection ferromagnétique (21, 22, 23) sont empilées perpendiculairement à un plan de couche ($P_L$) de celles-ci ;
   dans lequel au moins une portion (20) de l'élément magnétorésistif (2) comprenant la couche de détection ferromagnétique (23) a une forme en section transversale creuse (202) dans le plan de couche ($P_L$), la forme en section transversale creuse (202) ayant un côté extérieur (204) avec une taille latérale extérieure ($D_{out}$) et un côté intérieur (203) définissant une largeur ($w_d$) de la forme en section transversale creuse (202) ;
   dans lequel la taille latérale extérieure ($D_{out}$) est comprise entre 1 $\mu$m et 5 $\mu$m et la largeur ($w_d$) est comprise entre 0,2 $\mu$m et 0,3 $\mu$m ; de sorte que l'aimantation de détection (230) ait une configuration de vortex sans noyau et de sorte que l'élément magnétorésistif (2) ait une rémanence nulle à champ magnétique extérieur nul ($B_{ext}$) ;
   dans lequel la forme en section transversale creuse (202) comprend une caractéristique géométrique supplémentaire (30) configurée pour réduire localement la largeur ($w_d$) de la forme en section transversale creuse (202) de moins de 50 %, de manière à éviter la formation d'un noyau de vortex dans la magnétisation de détection (230) ; et
   dans lequel la caractéristique géométrique supplémentaire (30) comprend : le côté intérieur (203) ayant une forme ellipsoïdale et le côté extérieur (204) ayant une forme circulaire ; ou le côté extérieur (204) ayant une forme ellipsoïdale et le côté intérieur (203) ayant une forme circulaire.

2. Élément magnétorésistif selon la revendication 1,
   dans lequel la caractéristique géométrique supplémentaire (30) est agencée symétriquement par rapport au centre de la forme en section transversale creuse (202).

3. Élément magnétorésistif selon la revendication 1 ou 2,
   dans lequel la caractéristique géométrique supplémentaire (30) est agencée sensiblement perpendiculairement à la direction du champ magnétique externe ($B_{ext}$).

4. Commutateur magnétique comprenant l'élément magnétorésistif selon l'une quelconque des revendications 1 à 3.

Fig. 1a

Fig. 1b

Fig. 2

Fig. 3

Fig. 4

Fig. 5

Fig. 6a

Fig. 6b

Fig. 6c

Fig. 6d

Fig. 6e

Fig. 7

Fig. 8

Fig. 9

$D_{out}$

204

202

203

$D_{int}$

Fig. 10

$D_{out}$

204

202

$D_{int}$

203

$D_{int}$

Fig. 11

(a)

(b)

Fig. 12

(a)

(b)

Fig. 13

(a)

(b)

Fig. 14

Fig. 15

(a)

(b)

Fig. 16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005223158 A

**Non-patent literature cited in the description**

- **KLÄUI M et al.** Spin switching phase diagram of mesoscopic ring magnets. *Journal of Magnetism and Magnetic Materials*, 08 April 2005, vol. 290-291
- **NAKATANI R et al.** Magnetization reversal with in-plane magnetic field in asymmetric ring dots. *Japanese Journal of Applied Physics, Japan Society of Applied Physics*, 01 January 2003, vol. 42 (1)
- **M. KLÄUI et al.** Vortex formation in narrow ferromagnetic rings. *J. Phys. Cond. Matt.*, 2003, vol. 15, R985